# DEMANDE DE BREVET EUROPEEN

(11) **EP 4 195 537 A1**
(43) Date de publication de la demande: **14.06.2023**
(21) Numéro de dépôt: 22212947.0
(22) Date de dépôt: 12.12.2022
(51) Int. Cl.: H04B 15/00

(54) **DISPOSITIF ÉLECTRONIQUE**

(30) Priorité: 13.12.2021 FR 2113405
(71) Demandeur: ATEME, 78140 Velizy Villacoublay (FR)
(72) Inventeur: CAPITAN, Jean-Michel, 91430 VAUHALLAN (FR)
(74) Mandataire: Plasseraud IP

(57) **Abrégé**

Un dispositif électronique comprenant une carte électronique sur laquelle sont implantés un sous-ensemble analogique et une unité de filtrage, le sous-ensemble analogique comprenant un ou plusieurs composants analogiques radiofréquences de réception de signaux radiofréquences est proposé. Le sous-ensemble analogique est protégé par un blindage implanté sur une face de la carte électronique, l'unité de filtrage est implantée sur la face de la carte électronique sur un chemin de signal connecté électriquement au sous-ensemble analogique, l'unité de filtrage comprend un composant capacitif implanté sous le blindage et connecté à une masse analogique, et l'unité de filtrage comprend en outre un composant de filtrage placé en entrée de l'unité de filtrage en série sur le chemin de signal en traversée du blindage ou au voisinage immédiat de l'extérieur du blindage.

## Description

### Domaine technique

La présente divulgation se rapporte à un dispositif électronique. Elle s'applique notamment aux dispositifs électroniques d'acquisitions de signaux analogiques radiofréquences.

### Technique antérieure

Les dispositifs électroniques d'acquisition de signaux analogiques radiofréquences comprennent typiquement des composants analogiques formant un bloc analogique de réception de signaux analogiques radiofréquences, des composants d'un bloc d'alimentation du bloc analogique, ainsi que dans certains cas des composants numériques fournissant diverses fonctions, telle que par exemple une fonction de génération de signaux de contrôle du bloc analogique. Le bloc analogique est par ailleurs typiquement protégé des perturbations électromagnétiques extérieures par un capot de protection électromagnétique, afin notamment de préserver les performances des composants analogiques du bloc analogique qui seraient autrement dégradées par le bruit généré par les composants numériques et/ou les composants du bloc d'alimentation. Une unité de filtrage peut en outre être utilisée pour réaliser un filtrage entre le bloc analogique et les composants numériques couplés électriquement au bloc analogique et/ou entre le bloc analogique et les composants d'alimentation qui sont couplés électriquement au bloc analogique.

### Problème technique

L'efficacité du filtrage effectué par l'unité de filtrage peut alors fortement diminuer en fonction du placement de l'unité de filtrage sur le chemin de signal filtré.

### Résumé

Un objet de la présente invention est de remédier au moins partiellement aux inconvénients précités.

Selon un premier aspect, il est proposé un dispositif électronique comprenant une carte électronique sur laquelle sont implantés, un sous-ensemble analogique et une unité de filtrage, le sous-ensemble analogique comprenant un ou plusieurs composants analogiques, dans lequel le sous-ensemble analogique est protégé par un blindage implanté sur une face de la carte électronique, dans lequel l'unité de filtrage est implantée sur la face de la carte électronique sur un chemin de signal connecté électriquement au sous-ensemble analogique (par exemple connectant électriquement un ou plusieurs composants situés à l'extérieur du blindage au sous-ensemble analogique), dans lequel l'unité de filtrage comprend un composant capacitif implanté sous le blindage et connecté à une masse analogique, et dans lequel l'unité de filtrage comprend en outre un composant de filtrage placé en entrée de l'unité de filtrage en série sur le chemin de signal en traversée du blindage ou au voisinage immédiat de l'extérieur du blindage.

Le dispositif proposé permet avantageusement, grâce au placement du composant capacitif de l'unité de filtrage sous le blindage et au placement du composant de filtrage de l'unité de filtrage placé en entrée de l'unité de filtrage en série sur le chemin de signal en traversée du blindage ou au voisinage immédiat (soit à proximité immédiate, ou le plus proche possible) de l'extérieur du blindage, d'améliorer l'efficacité du filtrage des perturbations électromagnétiques générées par les composants extérieurs au blindage, qu'il s'agissent de composants sur la carte électronique (par exemple les composants d'un bloc perturbateur ou de composants externes à la carte électronique (par exemple les perturbations électromagnétiques générés par une alimentation d'un serveur informatique ou un PC dans lequel la carte électronique est insérée (par exemple sur un port d'extension)) qui autrement viendraient perturber, par couplage sur le signal pénétrant sous le blindage, le fonctionnement du sous-ensemble analogique.

Dans un ou plusieurs modes de réalisation, l'unité de filtrage du dispositif proposé comprend un composant de filtrage placé en entrée de l'unité de filtrage en série sur un chemin de signal connectant électriquement des composants (par exemple électroniques) situés à l'extérieur du blindage (par exemple un signal provenant d'un bloc perturbateur électromagnétique extérieur au blindage protégeant le sous-ensemble analogique) au sous-ensemble analogique, qui est avantageusement placé en traversée du blindage ou, selon le mode de réalisation choisi, à proximité immédiate du blindage (espacé le moins possible du blindage, par exemple du capot de blindage), de manière à filtrer efficacement toute perturbation électromagnétique extérieur au sous-ensemble analogique protégé par le blindage (par exemple placé sous un capot de blindage). Ce placement du composant de filtrage d'entrée de l'unité de filtrage au plus près du blindage ou, lorsque cela est possible, en traversée du blindage (et donc du capot lorsque le blindage comprend un capot), permet avantageusement de limiter, voire d'éviter, l'exposition du signal filtré en sortie de ce composant de filtrage au bruit électromagnétique susceptible de perturber le fonctionnement des composants protégés par le blindage. En effet, dans les modes de réalisation dans lesquels le composant de filtrage est placé au plus près du blindage, la longueur de la portion de chemin de signal en sortie de ce composant située à l'extérieur du blindage (portion de chemin de signal entre la sortie du composant de filtrage et le blindage) est réduite autant que possible pour éviter que cette portion de chemin ne capte du bruit électromagnétique environnant qui serait alors injecté avec le signal pénétrant le blindage, ou limite autant que possible la quantité de bruit capté. Dans les modes de réalisation dans lesquels le composant de filtrage est placé en traversée du blindage, le signal en sortie de ce composant n'est pas pollué par le bruit environnant puisqu'il est protégé par le blindage.

L'unité de filtrage du dispositif proposé comprend en outre un composant capacitif connecté à une masse analogique, situé en aval du composant de filtrage sur le chemin de signal, qui reçoit donc en entrée un signal filtré issu du composant de filtrage placé en série. Ce composant capacitif est implanté sous le blindage, et ainsi placé à l'intérieur du blindage (par exemple sous un capot de blindage protégeant le sous-ensemble analogique), afin de pouvoir placer le composant de filtrage, situé en amont, en traversée du blindage ou à proximité immédiate du blindage.

Ce composant capacitif de l'unité de filtrage se comportera comme un fil pour les signaux haute fréquence qui le traverseront, en particulier pour les signaux de bruit haute fréquence, et peut donc être utilisé pour diriger des perturbations haute fréquence présentes dans le signal en sortie du composant de filtrage vers la masse. Si ce composant capacitif de l'unité de filtrage était placé à l'extérieur du blindage protégeant le sous-ensemble analogique, le(s) composant(s) de filtrage filtrerai(en)t le bruit du signal le(s) traversant, mais ce bruit se trouverait couplé sur le composant capacitif de l'unité de filtrage par bruit électrique de masse, de sorte que le bruit filtré par le(s) composant(s) de filtrage se retrouverait tout de même du côté opposé à la masse numérique de(s) composant(s) de filtrage (ce bruit serait miroir du bruit de masse numérique présent en dehors du blindage), et pénétrerait le sous-ensemble analogique protégé par le blindage. L'unité de filtrage serait donc moins efficace, et le placement proposé du composant capacitif de l'unité de filtrage sous le blindage permet avantageusement d'éviter cet inconvénient.

L'efficacité de l'unité de filtrage telle que configurée dans le dispositif proposé est ainsi préservée, d'une part par le placement du composant de filtrage d'entrée de l'unité de filtrage (placé en série) au plus proche ou, selon le mode de réalisation, en traversée du blindage (par exemple du capot de blindage), et d'autre part par le placement du composant capacitif de sortie de l'unité de filtrage sous le blindage. Ainsi, selon le mode de réalisation choisi, le dispositif proposé permet avantageusement de préserver (et donc d'améliorer par rapport aux configurations existantes) l'efficacité du filtrage effectué par l'unité de filtrage entre le sous-ensemble analogique et le sous-ensemble numérique, ou entre le sous-ensemble analogique et le sous-ensemble d'alimentation.

Selon un autre aspect, il est proposé un dispositif électronique comprenant une carte électronique sur laquelle sont implantés, un sous-ensemble analogique et une unité de filtrage, le sous-ensemble analogique comprenant un ou plusieurs composants analogiques, dans lequel le sous-ensemble analogique est protégé par un blindage implanté sur une face de la carte électronique, dans lequel l'unité de filtrage est implantée sur la face de la carte électronique sur un chemin de signal connectant électriquement un ou plusieurs composants à l'extérieur du blindage au sous-ensemble analogique, dans lequel l'unité de filtrage comprend un composant capacitif implanté sous le blindage et connecté à une masse analogique, et dans lequel l'unité de filtrage comprend en outre un composant de filtrage placé en entrée de l'unité de filtrage en série sur le chemin de signal en traversée du blindage ou au voisinage immédiat de l'extérieur du blindage.

Selon encore un autre aspect, il est proposé un dispositif électronique comprenant une carte électronique sur laquelle sont implantés, sur une face de la carte électronique, un sous-ensemble analogique, un bloc alimentation/numérique, et une unité de filtrage, le sous-ensemble analogique comprenant un ou plusieurs composants analogiques le bloc alimentation/numérique comprenant un sous-ensemble numérique et/ou un sous-ensemble d'alimentation, le sous-ensemble numérique comprenant un ou plusieurs composants numériques, et le sous ensemble d'alimentation comprenant un ou plusieurs composants d'alimentation électrique du sous-ensemble analogique, dans lequel le sous-ensemble analogique est protégé par un blindage implanté sur la face de la carte électronique, dans lequel l'unité de filtrage est implantée sur un chemin de signal entre le sous-ensemble analogique et le bloc alimentation/numérique, dans lequel l'unité de filtrage comprend un composant capacitif implanté sous le blindage, et dans lequel l'unité de filtrage comprend un composant de filtrage placé en série sur le chemin de signal en traversée du blindage ou au voisinage immédiat du blindage.

Le dispositif proposé dans cet aspect permet avantageusement, grâce au placement du composant capacitif de l'unité de filtrage sous le blindage et au placement du composant de filtrage de l'unité de filtrage placé en entrée de l'unité de filtrage en série sur le chemin de signal en traversée du blindage ou au voisinage immédiat (soit à proximité immédiate, ou le plus proche possible) de l'extérieur du blindage, d'améliorer l'efficacité du filtrage entre, d'une part, le sous-ensemble analogique comprenant un ou plusieurs composants analogiques et protégé des perturbations électromagnétiques extérieures par un blindage (comprenant par exemple un capot de blindage protégeant le ou les composants du sous-ensemble analogique) et, d'autre part, le bloc alimentation/numérique, en ce que le placement de ces composants tel que proposé permet d'éviter une diminution de l'efficacité de filtrage de l'unité de filtrage.

Selon encore un autre aspect, il est proposé un dispositif électronique comprenant une carte électronique sur laquelle sont implantés un sous-ensemble analogique, un bloc alimentation/numérique, et une unité de filtrage, le sous-ensemble analogique comprenant un ou plusieurs composants analogiques radiofréquences de réception radiofréquence faible niveau, le bloc alimentation/numérique comprenant un sous-ensemble numérique et/ou un sous-ensemble d'alimentation, le sous-ensemble numérique comprenant un ou plusieurs composants numériques, et le sous ensemble d'alimentation comprenant un ou plusieurs composants d'alimentation électrique du sous-ensemble d'alimentation, dans lequel le sous-ensemble analogique est protégé par un capot de blindage, dans lequel l'unité de filtrage est implantée sur un chemin de signal entre le sous-ensemble analogique et le bloc alimentation/numérique, et dans lequel l'unité de filtrage est placée sur le chemin de signal en traversée du capot de blindage ou au voisinage immédiat du capot de blindage.

Les caractéristiques exposées dans les paragraphes suivants peuvent, optionnellement, être mises en oeuvre. Elles peuvent être mises en oeuvre indépendamment les unes des autres ou en combinaison les unes avec les autres :

Dans un ou plusieurs modes de réalisation, le sous-ensemble analogique comprend un ou plusieurs composants analogiques de réception de signaux radiofréquences.

Dans un ou plusieurs modes de réalisation, le dispositif comprend en outre un bloc alimentation/numérique implanté sur la carte électronique, le bloc alimentation/numérique comprenant un sous-ensemble numérique et/ou un sous-ensemble d'alimentation, le sous-ensemble numérique comprenant un ou plusieurs composants numériques, et le sous ensemble d'alimentation comprenant un ou plusieurs composants d'alimentation électrique du sous-ensemble analogique, et l'unité de filtrage est implantée entre le sous-ensemble analogique et le bloc alimentation/numérique.

Dans un ou plusieurs modes de réalisation, le chemin de signal est entre le sous-ensemble analogique et le sous-ensemble numérique, ce qui permet avantageusement d'utiliser l'unité de filtrage dans la configuration proposée pour filtrer les signaux entre le sous-ensemble analogique et le sous-ensemble numérique. Par exemple, dans un ou plusieurs modes de réalisation, l'unité de filtrage est configurée pour filtrer un signal de contrôle issu du sous-ensemble numérique pour contrôler le sous-ensemble analogique, par exemple pour le configurer (par exemple un signal de contrôle au format I2C).

Dans un ou plusieurs modes de réalisation, le chemin de signal est entre le sous-ensemble analogique et le sous-ensemble d'alimentation, ce qui permet avantageusement d'utiliser l'unité de filtrage dans la configuration proposée pour filtrer les signaux entre le sous-ensemble analogique et le sous-ensemble d'alimentation. Par exemple, dans un ou plusieurs modes de réalisation, l'unité de filtrage est configurée pour filtrer un signal d'alimentation issu du sous-ensemble alimentation pour alimenter électriquement le sous-ensemble analogique.

Dans un ou plusieurs modes de réalisation, l'unité de filtrage comprend une cellule de filtrage de type LC ou RC.

Dans un ou plusieurs modes de réalisation, le blindage comprend un capot de blindage, et le composant de filtrage placé en série sur le chemin de signal est placé en traversée du capot de blindage ou au voisinage immédiat du capot de blindage.

Dans un ou plusieurs modes de réalisation, le blindage comprend un capot de blindage, et le composant de filtrage placé en série est un composant inductance placé en série à cheval sous le capot de blindage entre le bloc alimentation/numérique et le sous-ensemble analogique.

Dans d'autres modes de réalisation, le blindage comprend un capot de blindage, et le composant de filtrage placé en série est un composant résistif placé en série à cheval sous le capot de blindage entre le bloc alimentation/numérique et le sous-ensemble analogique.

### Brève description des dessins

D'autres particularités et avantages de la présente invention apparaîtront dans la description ci-après d'exemples de réalisation non limitatifs, en référence aux dessins annexés, dans lesquels :
**Fig. 1a**

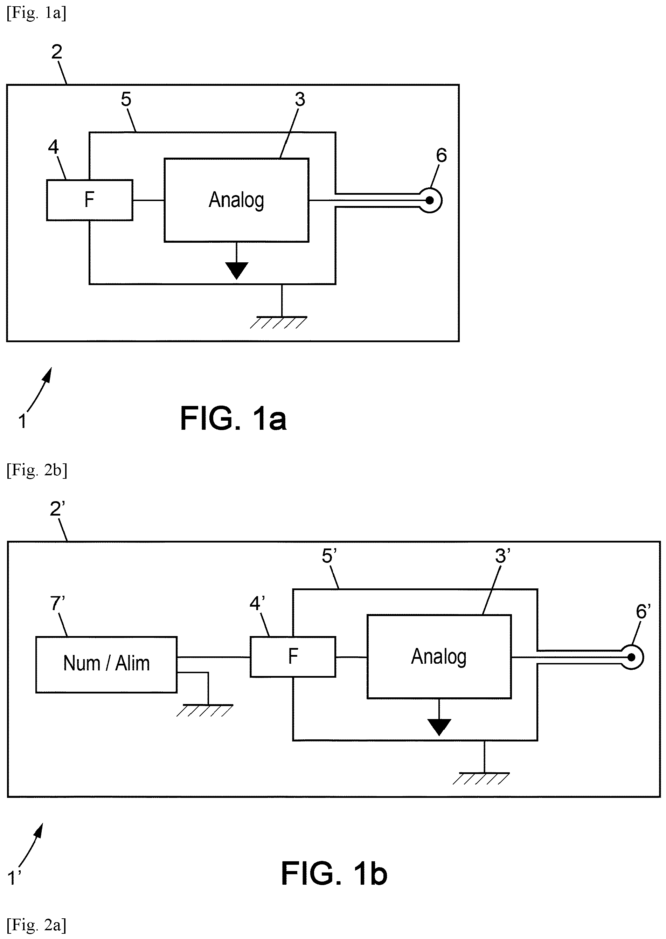

   [Fig. 1a] est un schéma illustrant un exemple de dispositif électronique selon un ou plusieurs modes de réalisation ;
**Fig. 1b**
   [Fig. 1b] est un schéma illustrant un exemple de dispositif électronique selon un ou plusieurs modes de réalisation ;
**Fig. 2a**

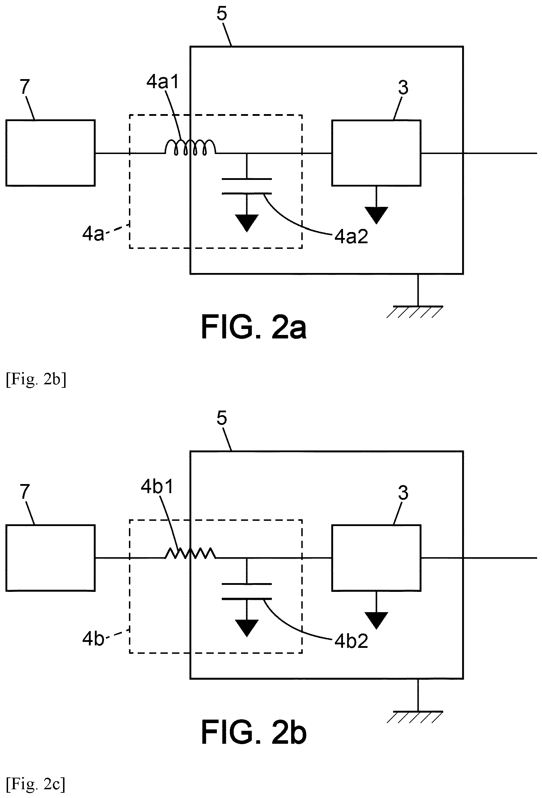

   [Fig. 2a] est un schéma illustrant un exemple d'unité de filtrage selon un ou plusieurs modes de réalisation ;
**Fig. 2b**
   [Fig. 2b] est un schéma illustrant un exemple d'unité de filtrage selon un ou plusieurs modes de réalisation ;
**Fig. 2c**

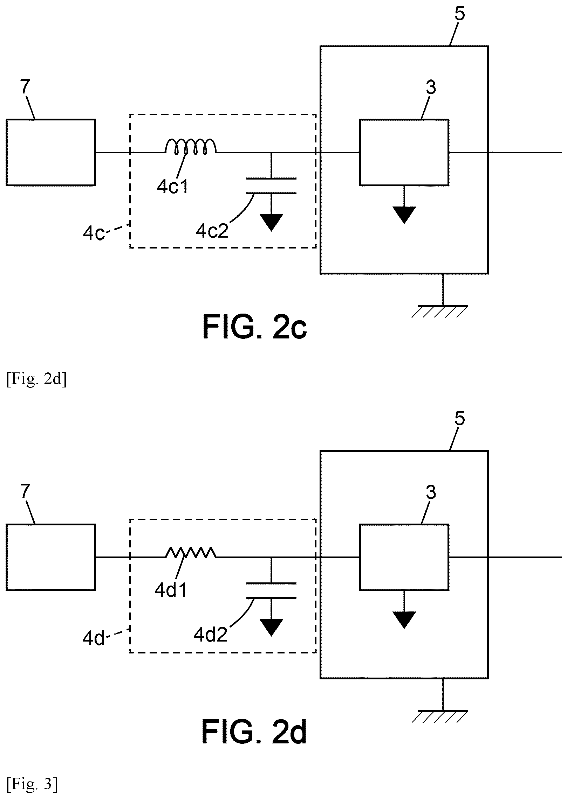

   [Fig. 2c] est un schéma illustrant un exemple d'unité de filtrage selon un ou plusieurs modes de réalisation ;
**Fig. 2d**
   [Fig. 2d] est un schéma illustrant un exemple d'unité de filtrage selon un ou plusieurs modes de réalisation ;
**Fig. 3**

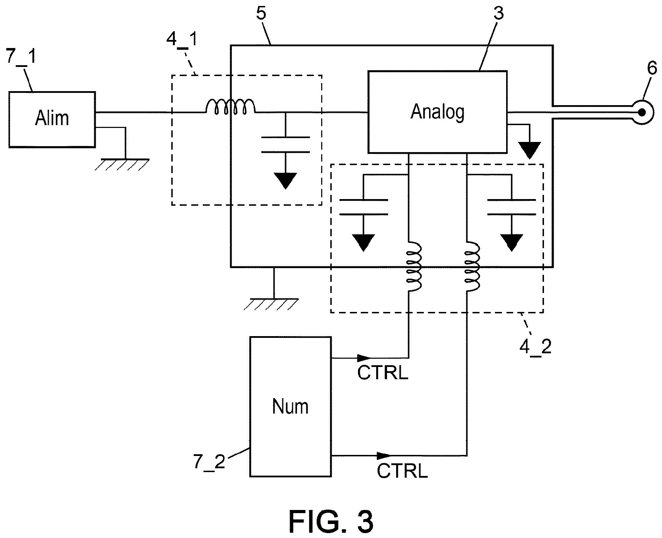

   [Fig. 3] est un schéma illustrant un exemple de dispositif électronique selon un ou plusieurs modes de réalisation.

### Description des modes de réalisation

Dans la description détaillée ci-après de modes de réalisation de l'invention, de nombreux détails spécifiques sont présentés pour apporter une compréhension plus complète. Néanmoins, l'homme du métier peut se rendre compte que des modes de réalisation peuvent être mis en pratique sans ces détails spécifiques. Dans d'autres cas, des caractéristiques bien connues ne sont pas décrites en détail pour éviter de compliquer inutilement la présente description.

La présente demande fait référence à des fonctions, moteurs, unités, modules, plateformes, et illustrations de diagrammes des méthodes et dispositifs selon un ou plusieurs modes de réalisation. Sauf mention contraire dans les présentes, chacun des fonctions, moteurs, modules, plateformes, unités et diagrammes décrits peut être mis en oeuvre sous forme matérielle, logicielle (y compris sous forme de logiciel embarqué (« firmware »), ou de « middleware »), microcode, ou toute combinaison de ces derniers. Dans le cas d'une mise en oeuvre sous forme logicielle, les fonctions, moteurs, unités, modules et/ou illustrations de diagrammes peuvent être mis en oeuvre par des instructions de programme d'ordinateur ou du code logiciel, qui peut être stocké ou transmis sur un support lisible par ordinateur, incluant un support non transitoire, ou un support chargé en mémoire d'un ordinateur générique, spécifique, ou de tout autre appareil ou dispositif programmable de traitement de données pour produire une machine, de telle sorte que les instructions de programme d'ordinateur ou le code logiciel exécuté(es) sur l'ordinateur ou l'appareil ou dispositif programmable de traitement de données, constituent des moyens de mise en oeuvre de ces fonctions.

De plus, les termes «notamment», «par exemple», «exemple», «typiquement» sont utilisés dans la présente description pour désigner des exemples ou illustrations de modes de réalisation non limitatifs, qui ne correspondent pas nécessairement à des modes de réalisation préférés ou avantageux par rapport à d'autres aspects ou modes de réalisation possibles.

Les expressions « sous-ensemble analogique » et « partie analogique » sont utilisées de manière indifférenciée dans la présente description pour désigner des sous-ensembles d'un ou de plusieurs composants électroniques (qui sont alors dits « analogiques ») configurés pour traiter des signaux analogiques. Les expressions « sous-ensemble radiofréquences », « sous-ensemble analogique/radiofréquences », et « partie radiofréquences » sont utilisées de manière indifférenciée dans la présente description pour désigner des sous-ensembles d'un ou de plusieurs composants électroniques (qui sont alors dits « analogiques radiofréquences » ou « radiofréquences ») configurés pour traiter des signaux radiofréquences analogiques. Les expressions « sous-ensemble numérique » et « partie numérique » sont utilisées de manière indifférenciée dans la présente description pour désigner des sous-ensembles comprenant un ou plusieurs composants électroniques (qui sont alors dits « numériques ») configurés pour traiter des signaux numériques et/ou des composants d'alimentation électrique. Les expressions « sous-ensemble alimentation » et « partie alimentation » sont utilisées de manière indifférenciée dans la présente description pour désigner des sous-ensembles d'alimentation électrique comprenant un ou plusieurs composants électroniques (qui sont alors dits « d'alimentation électrique » ou « d'alimentation »)

Les termes «couplé de manière opérationnelle», «couplé», «connecté» et leurs variantes et formes diverses utilisés dans les présentes font référence à des couplages et connexions physiques, électriques, électroniques ou mécaniques, qui peuvent être directs ou indirects, et comprennent notamment des connexions entre composants électroniques (par exemple sous forme de piste de cuivre, par exemple sur un circuit imprimé), entre des équipements électroniques ou entre des portions de tels équipements qui permettent des opérations et fonctionnements tels que décrits dans la présente demande.

La figure la illustre un exemple de dispositif électronique selon un ou plusieurs modes de réalisation.

Le dispositif 1 de la figure la comprend une carte électronique 2 sur laquelle sont implantés un sous-ensemble analogique 3, une unité de filtrage 4, et une interface d'entrée 6.

Le sous-ensemble analogique 3 est protégé des perturbations électromagnétiques extérieures par un blindage, comprenant par exemple un capot de blindage 5. Le capot de blindage permet de protéger efficacement les signaux électroniques circulant sous le capot de blindage ne soient pas perturbés par le bruit, et notamment le bruit haute fréquence qui se trouve en dehors du capot de blindage 5. Dans un ou plusieurs modes de réalisation, le blindage protégeant le sous-ensemble analogique du bruit électromagnétique environnant comprend un capot de blindage 5 et une ou plusieurs couches (non représentées sur la figure) de cuivre de masse (de préférence analogique) formées dans le cuivre du circuit imprimé de la carte électronique 2 en fermeture de blindage dans la carte électronique et en regard du capot de blindage 5.

Le bruit (électromagnétique) susceptible d'affecter le fonctionnement ou les performances des composants du sous-ensemble analogique 3 peut être généré par un ou plusieurs composants de l'environnement électronique du dispositif électronique 1 bruité car non protégé par le capot de blindage 5, environnement qui forme un « monde extérieur » au sous-ensemble analogique 3 que l'on cherche à protéger. En fonction du mode de réalisation, ces composants peuvent comprendre des composants de sous-ensembles d'alimentation et/ou numériques implantés sur la carte électronique 2 (non représentés sur la figure) et/ou des composants de sous-ensembles d'alimentation et/ou numériques (non représentés sur la figure) extérieurs au dispositif électronique 1, comme par exemple les composants d'une alimentation électrique d'une plateforme de type serveur au sein de laquelle le dispositif électronique 1 est inséré.

Dans un ou plusieurs modes de réalisation, le sous-ensemble analogique 3 comprend un ou plusieurs composants de traitement de signaux analogiques, par exemple de très faible amplitude.

En particulier, le dispositif proposé trouvera avantageusement à s'appliquer pour un sous-ensemble analogique 3 du type comprenant un ou plusieurs composants de traitement de signaux analogiques de très faible niveau. Du fait de la sensibilité de ce type de sous-ensemble analogique à des niveaux de bruit qui sont comparables, voire même plus faible que le niveau de signal traité par les composants du sous-ensemble analogique 3 (qui sera par exemple de l'ordre de quelques µV), le fonctionnement du sous-ensemble analogique aux performances attendues ne pourra être obtenu qu'en protégeant ce sous-ensemble analogique du bruit extérieur (incluant les perturbations électromagnétiques extérieures) par un blindage, comprenant par exemple un capot de blindage 5 implanté sur une face de la carte électronique 2. L'utilisation d'un blindage sera d'autant plus indiqué dans les cas de figure dans lesquels le niveau de bruit est plus important que celui des signaux traités par le sous-ensemble analogique 3 (niveau de bruit qui sera par exemple de l'ordre de quelques dizaines ou centaines de µV, soit donc plus important que celui des signaux analogiques traités par le sous-ensemble analogique).

Dans un ou plusieurs modes de réalisation, le sous-ensemble analogique 3 comprend un ou plusieurs composants de traitement de signaux analogiques radiofréquences, par exemple de signaux radiofréquences haute fréquence (HF).

En particulier, le dispositif proposé trouvera avantageusement à s'appliquer pour un sous-ensemble analogique 3 du type comprenant un ou plusieurs composants analogiques de réception radiofréquences, par exemple à faible niveau. Du fait de la sensibilité de ce type de sous-ensemble analogique à des niveaux de bruit qui sont comparables, voire même plus faible que le niveau de signal traité par les composants du sous-ensemble analogique 3 (qui sera par exemple, pour des signaux de réception satellite, de l'ordre de quelques dBµV), le fonctionnement du sous-ensemble analogique aux performances attendues ne pourra être obtenu qu'en protégeant ce sous-ensemble analogique du bruit extérieur (incluant les perturbations électromagnétiques extérieures) par un blindage, comprenant par exemple un capot de blindage 5 implanté sur une face de la carte électronique 2. L'utilisation d'un blindage sera d'autant plus indiqué dans les cas de figure dans lesquels le niveau de bruit est plus important que celui des signaux traités par le sous-ensemble analogique 3 (niveau de bruit qui sera par exemple de l'ordre de quelques dizaines ou centaines de dBµV, soit donc beaucoup plus important que celui des signaux de réception satellite).

L'unité de filtrage 4 du système 1 est implantée sur un chemin de signal connecté électriquement au sous-ensemble analogique 3. Par exemple, dans un ou plusieurs modes de réalisation, l'unité de filtrage 4 du système 1 est implantée sur un chemin de signal connectant électriquement un ou plusieurs composants (par exemple électriques ou électroniques) situés à l'extérieur du blindage (par exemple implantés sur la carte électronique 2, comme illustré par la figure 1b) au sous-ensemble analogique 3. Par ailleurs, l'unité de filtrage 4 comprend un composant capacitif implanté sous le capot 5 et connecté à une masse analogique protégée par le blindage 5, et un composant de filtrage implanté en série et placé en entrée de l'unité de filtrage 4 sur le chemin de signal en traversée du capot de blindage 5 ou, selon le mode de réalisation choisi, à proximité immédiate du capot 5 de blindage, de manière à avantageusement augmenter l'efficacité de filtrage des signaux issus du « monde extérieur » au sous-ensemble analogique 3 (signaux issus de l'environnement électronique du dispositif électronique 1 bruité car non protégé par le capot de blindage 5) routés vers le sous-ensemble analogique 3 à l'intérieur du capot 5, afin de protéger le fonctionnement du sous-ensemble analogique des perturbations électromagnétiques portées par ces signaux. Dans un ou plusieurs modes de réalisation, l'unité de filtrage 4 peut ainsi comprendre, en entrée, un composant de filtrage placé en série sur le chemin de signal en traversée du blindage ou au voisinage immédiat du blindage, et en sortie un composant capacitif implanté sous le blindage.

Avantageusement, le composant de filtrage et le composant capacitif de l'unité de filtrage 4 seront implantés sur la même face de la carte électronique que celle sur laquelle sont implantés le capot de blindage 5 et le sous-ensemble analogique 3, de sorte que l'unité de filtrage 4 sera implantée, du moins en partie, sur la même face de la carte électronique que celle sur laquelle est implanté le capot de blindage 5, sur un chemin de signal connecté au sous-ensemble analogique 3 protégé par le blindage 5.

Dans un ou plusieurs modes de réalisation, le dispositif électronique 1 comprend une carte électronique 2 sur laquelle est mis en oeuvre un circuit imprimé pour l'implantation et le routage de composants électroniques sur la carte électronique 2. Dans un ou plusieurs modes de réalisation, le composant de filtrage placé en série et le composant capacitif de l'unité de filtrage 4 sont implantés sur la même face de la carte électronique que celle sur laquelle sont implantés les composants du sous-ensemble analogique 3 et le capot de blindage 5. Dans un ou plusieurs modes de réalisation, l'unité de filtrage 4 est implantée sur la même face de la carte électronique que celle sur laquelle sont implantés les composants du sous-ensemble analogique 3 et le capot de blindage 5.

Le composant de l'unité de filtrage 4 recevant le signal d'entrée de l'unité de filtrage 4 (qui peut être, selon les modes de réalisation, un composant inductif ou un composant résistif) est placé, selon les modes de réalisation, en traversée du capot 5 ou à proximité immédiate du capot 5 à l'extérieur de celui-ci. Ainsi, le signal d'entrée (à filtrer) de l'unité de filtrage 4 ne pénètre pas sous le capot de blindage 5, de manière à ne pas perturber le fonctionnement ou les performances des composants du sous-ensemble analogique 3.

A l'inverse, le composant capacitif de l'unité de filtrage 4 est placé sous le capot de blindage 5, de manière à faire le lien avec l'environnement électronique non bruité du sous-ensemble analogique 3 car protégé par le capot de blindage 5.

Ainsi, le composant d'entrée de l'unité de filtrage 4, placé en série en traversée du capot 5 ou à proximité immédiate du capot 5, fait le lien avec l'environnement électronique du dispositif électronique 1 bruité (car non protégé par le capot de blindage 5), tandis que le composant (capacitif) de sortie de l'unité de filtrage 4, placé sous le capot de blindage 5, fait le lien avec l'environnement électronique non bruité du sous-ensemble analogique 3 car protégé par le capot de blindage 5.

Si le composant capacitif de sortie de l'unité de filtrage 4 était placé à l'extérieur du capot de blindage 5, l'ensemble de l'unité de filtrage 4 serait placé à l'extérieur du capot de blindage 5, de sorte que le signal filtré (débruité) en sortie de l'unité de filtrage 4 pourrait à nouveau être bruité avant de pénétrer sous le capot de blindage 5. L'efficacité de l'unité de filtrage 4 s'en trouverait donc potentiellement fortement amoindrie. En effet, le composant capacitif de l'unité de filtrage 4, s'il était placé à l'extérieur du capot de blindage 5, pourrait lui-même capter du bruit électromagnétique environnant qui viendrait s'ajouter au signal en sortie de l'unité de filtrage 4 et dirigé vers le sous-ensemble analogique 3. De plus, si le composant capacitif de sortie de l'unité de filtrage 4 était placé à l'extérieur du capot de blindage 5, il serait impossible de placer le composant de filtrage d'entrée de l'unité de filtrage 4 placé en série (sur le chemin de signal) en traversée ou à proximité immédiate du capot de blindage 5.

Dans un ou plusieurs modes de réalisation, le composant capacitif de l'unité de filtrage 4 (placé sous le capot de blindage 5) permet de créer un chemin de signal de très basse impédance à haute fréquence destiné à favoriser le passage de la composante haute fréquence des signaux à filtrer.

Dans un ou plusieurs modes de réalisation, le composant capacitif de l'unité de filtrage 4 peut être connecté à une masse de manière à diriger vers cette masse les signaux haute fréquence, ce qui permet de filtrer la composante haute fréquence des signaux à filtrer.

Dans un ou plusieurs modes de réalisation, le circuit imprimé de la carte électronique 2 peut être configuré avec un plan de masse comprenant une masse analogique et une masse numérique (parfois aussi appelée masse mécanique) distinctes l'une de l'autre. Sur les figures, une masse numérique est représentée par un symbole râteau, tandis qu'une masse analogique est représentée par une flèche pointant vers le bas. Les masses numériques sont des masses prévues pour recevoir des signaux bruités (par exemple par du bruit de commutation numérique), tandis que les masses analogiques sont, au contraire des masses numériques, prévues pour être isolées de ces signaux bruités. Dans l'exemple de la figure la, la partie analogique, comprenant l'interface d'entrée 6 et le sous-ensemble analogique 3, utilise une masse analogique.

Dans un ou plusieurs modes de réalisation, la masse à laquelle est connectée le composant capacitif de l'unité de filtrage 4 (placé sous le capot de blindage 5) sera de préférence une masse analogique, de manière à éviter que du bruit remonte depuis une masse numérique (connecté au composant capacitif) au travers du composant capacitif pour venir perturber le fonctionnement ou les performances du sous-ensemble analogique. Dans un ou plusieurs modes de réalisation, la masse présente à l'intérieur du blindage 5, zone dans laquelle le composant capacitif de l'unité de filtrage 4 sera implanté, sera d'ailleurs de type analogique afin de protéger les composants de cette zone du bruit de masse.

Dans un ou plusieurs modes de réalisation, l'unité de filtrage 4 réalise ainsi une structure filtrante des signaux en entrée par un composant de filtrage (par exemple une inductance et/ou une résistance) placé en traversée du blindage ou à proximité immédiate du blindage (par exemple placé à l'extérieur, mais au plus proche, voire collé au blindage), et les signaux haute fréquence ayant traversé le composant de filtrage (qui constituent des perturbations haute fréquence isolées par le composant de filtrage en entrée de l'unité de filtrage 4) et pénétrant sous le capot de blindage 5 vont être dirigés vers la masse par un composant capacitif de l'unité de filtrage 4 placé sous le capot de blindage 5 et connecté à une masse analogique.

Le type ou les paramètres de filtrage de l'unité de filtrage 4, et notamment la bande passante, pourront bien entendu être choisis en fonction du filtrage souhaité.

Par exemple, en fonction du mode de réalisation, l'unité de filtrage 4 peut comprendre un composant inductance L et être configurée pour mettre en oeuvre une cellule de filtrage de type LC, ou comprendre un composant résistif R et être configurée pour mettre en oeuvre une cellule de filtrage de type RC.

La Figure la illustre un exemple d'interface d'entrée 6 du dispositif 1 configurée pour la réception d'un signal d'entrée radiofréquences, par exemple un signal HF, et être couplée au sous-ensemble analogique 3 pour traitement du signal reçu sur l'interface d'entrée 6 par le sous-ensemble analogique 3. Par exemple, dans un ou plusieurs modes de réalisation, l'interface d'entrée 6 est alimentée par un bloc d'alimentation faible bruit (non représenté sur la figure) et est agencée pour recevoir un signal de diffusion vidéo modulé d'entrée dans une bande de fréquences d'entrée.

Comme illustré par la Figure la, dans un ou plusieurs modes de réalisation, l'interface d'entrée 6 pourra être protégée par le blindage, et par exemple être coaxiale, afin par exemple de pouvoir avantageusement connecter au dispositif 1 un câble coaxial de réception de signaux radiofréquences, comme par exemple un câble de réception de signaux vidéo diffusés par satellite, par reprise de blindage à 360 degrés (sur tout le pourtour du câble) pour protéger l'interface d'entrée 6 par le blindage.

La figure 1a illustre donc une unité de filtrage 4 comprenant un composant de filtrage (placé, en entrée de l'unité de filtrage, en série sur un chemin de signal connecté au sous-ensemble analogique 3) et un composant capacitif implanté sous le blindage, dont au moins un composant est, en tout ou partie, implanté à l'extérieur du blindage (composant de filtrage), et au moins un autre composant est implanté à l'intérieur du blindage (composant capacitif). Selon le mode de réalisation, le composant de filtrage est positionné en traversée du capot 5 protégeant le sous-ensemble analogique 3 des perturbations électromagnétiques ou, selon le mode de réalisation, positionné au voisinage immédiat de l'extérieur du blindage 5. Dans un ou plusieurs modes de réalisation, le composant de filtrage placé en série est implanté en traversée du blindage (par exemple en traversée du capot de blindage du blindage protégeant le sous-ensemble analogique 3), auquel cas le composant de filtrage est pour partie à l'extérieur du blindage et pour partie à l'intérieur du blindage, de sorte que le signal en sortie de ce composant est alors protégé par le blindage. Dans d'autres modes de réalisation, ce composant de filtrage placé en série est implanté à l'extérieur du blindage et à proximité immédiate du blindage (par exemple en traversée du capot de blindage du blindage protégeant le sous-ensemble analogique 3), auquel cas le composant de filtrage est implanté à l'extérieur du blindage mais à proximité immédiate de ce blindage de sorte que la longueur du chemin de signal entre la sortie de ce composant et le blindage 5 soit aussi courte que possible (étant donné les contraintes d'implantation des éléments électroniques sur la carte 2), afin de minimiser autant que possible le chemin de signal en sortie du composant de filtrage placé en série qui n'est pas protégé par le blindage.

La Figure 1b illustre un exemple de dispositif électronique selon un ou plusieurs modes de réalisation, dans lequel un bloc alimentation/numérique générateur de perturbations électromagnétiques est implanté sur la carte électronique du dispositif.

Le dispositif 1' de la Figure 1b comprend une carte électronique 2' sur laquelle sont implantés un sous-ensemble analogique 3', un bloc alimentation/numérique 7', une unité de filtrage 4', et une interface d'entrée 6'.

Le sous-ensemble analogique 3' est protégé des perturbations électromagnétiques extérieures par un blindage, comprenant par exemple un capot de blindage 5'. Le capot de blindage 5' permet de protéger efficacement les signaux électroniques circulant sous le capot de blindage 5' pour permettre qu'ils ne soient pas perturbés par le bruit, et notamment le bruit haute fréquence qui se trouve en dehors du capot de blindage 5'. Dans un ou plusieurs modes de réalisation, le blindage protégeant le sous-ensemble analogique du bruit électromagnétique environnant comprend un capot de blindage 5' et une ou plusieurs couches (non représentées sur la figure) de cuivre de masse (de préférence analogique) formées dans le cuivre du circuit imprimé de la carte électronique 2' en fermeture de blindage dans la carte électronique et en regard du capot de blindage 5'.

Le bruit (électromagnétique) susceptible d'affecter le fonctionnement ou les performances des composants du sous-ensemble analogique 3' peut être généré par un ou plusieurs composants de l'environnement électronique du dispositif électronique 1 bruité car non protégé par le capot de blindage 5, environnement qui forme un « monde extérieur » au sous-ensemble analogique 3 que l'on cherche à protéger, et notamment par un ou plusieurs des composants du bloc alimentation/numérique 7', et/ou par un ou plusieurs composants de sous-ensembles d'alimentation et/ou numériques (non représentés sur la figure) extérieurs au dispositif électronique 1', comme par exemple les composants d'une alimentation électrique d'une plateforme de type serveur au sein de laquelle le dispositif électronique 1' est inséré.

Dans un ou plusieurs modes de réalisation, le sous-ensemble analogique 3' comprend un ou plusieurs composants de traitement de signaux analogiques, par exemple de très faible amplitude.

En particulier, le dispositif proposé trouvera avantageusement à s'appliquer pour un sous-ensemble analogique 3' du type comprenant un ou plusieurs composants de traitement de signaux analogiques de très faible niveau. Du fait de la sensibilité de ce type de sous-ensemble analogique à des niveaux de bruit qui sont comparables, voire même plus faible que le niveau de signal traité par les composants du sous-ensemble analogique 3' (qui sera par exemple de l'ordre de quelques µV), le fonctionnement du sous-ensemble analogique aux performances attendues ne pourra être obtenu qu'en protégeant ce sous-ensemble analogique du bruit extérieur (incluant les perturbations électromagnétiques extérieures) par un blindage, comprenant par exemple un capot de blindage 5' implanté sur une face de la carte électronique 2'. L'utilisation d'un blindage sera d'autant plus indiqué dans les cas de figure dans lesquels le niveau de bruit est plus important que celui des signaux traités par le sous-ensemble analogique 3' (niveau de bruit qui sera par exemple de l'ordre de quelques dizaines ou centaines de µV, soit donc plus important que celui des signaux analogiques traités par le sous-ensemble analogique).

Dans un ou plusieurs modes de réalisation, le sous-ensemble analogique 3' comprend un ou plusieurs composants de traitement de signaux analogiques radiofréquences, par exemple de signaux radiofréquences haute fréquence (HF).

En particulier, le dispositif proposé trouvera avantageusement à s'appliquer pour un sous-ensemble analogique 3' du type comprenant un ou plusieurs composants analogiques de réception radiofréquences, par exemple à faible niveau. Du fait de la sensibilité de ce type de sous-ensemble analogique à des niveaux de bruit qui sont comparables, voire même plus faible que le niveau de signal traité par les composants du sous-ensemble analogique 3' (qui sera par exemple, pour des signaux de réception satellite, de l'ordre de quelques dBµV), le fonctionnement du sous-ensemble analogique aux performances attendues ne pourra être obtenu qu'en protégeant ce sous-ensemble analogique du bruit extérieur (incluant les perturbations électromagnétiques extérieures) par un blindage, comprenant par exemple un capot de blindage 5' implanté sur une face de la carte électronique 2'. L'utilisation d'un blindage sera d'autant plus indiqué dans les cas de figure dans lesquels le niveau de bruit est plus important que celui des signaux traités par le sous-ensemble analogique 3' (niveau de bruit qui sera par exemple de l'ordre de quelques dizaines ou centaines de dBµV, soit donc beaucoup plus important que celui des signaux de réception satellite).

L'unité de filtrage 4' du système 1' est implantée sur un chemin de signal entre le sous-ensemble analogique 3' et le bloc alimentation/numérique 7'. Par ailleurs, l'unité de filtrage 4' comprend un composant capacitif implanté sous le capot 5' et connecté à une masse analogique protégée par le blindage 5', et un composant de filtrage implanté en série et placé sur le chemin de signal en traversée du capot de blindage 5' ou, selon le mode de réalisation choisi, à proximité immédiate du capot 5' de blindage, de manière à avantageusement augmenter l'efficacité de filtrage des signaux issus du bloc alimentation/numérique 7', ainsi que d'autres signaux issus de composants extérieurs au dispositif 1', routés vers le sous-ensemble analogique 3' à l'intérieur du capot 5'. Dans un ou plusieurs modes de réalisation, l'unité de filtrage 4' peut ainsi comprendre, en entrée, un composant de filtrage placé en série sur le chemin de signal en traversée du blindage ou au voisinage immédiat du blindage, et en sortie un composant capacitif implanté sous le blindage.

Avantageusement, le composant de filtrage et le composant capacitif de l'unité de filtrage 4' seront implantés sur la même face de la carte électronique que celle sur laquelle est implanté le capot de blindage 5', de sorte que l'unité de filtrage 4' sera implantée, du moins en partie sur la même face de la carte électronique que celle sur laquelle est implanté le capot de blindage 5', sur un chemin de signal entre le sous-ensemble analogique 3' protégé par le blindage 5' et le bloc alimentation/numérique 7' implanté à l'extérieur du blindage.

Dans un ou plusieurs modes de réalisation, le dispositif électronique 1' comprend une carte électronique 2' sur laquelle est mis en oeuvre un circuit imprimé pour l'implantation et le routage de composants électroniques sur la carte électronique 2'. Dans un ou plusieurs modes de réalisation, le composant de filtrage placé en série et le composant capacitif de l'unité de filtrage 4' sont implantés sur la même face de la carte électronique que celle sur laquelle sont implantés les composants du sous-ensemble analogique 3' et le capot de blindage 5'. Dans un ou plusieurs modes de réalisation, l'unité de filtrage 4' est implantée sur la même face de la carte électronique que celle sur laquelle sont implantés les composants du sous-ensemble analogique 3' et le capot de blindage 5'. En fonction du mode de réalisation, un ou plusieurs des composants du bloc alimentation/numérique 7' peuvent être implantés sur la même face de la carte électronique que celle sur laquelle sont implantés les composants du sous-ensemble analogique 3' et le capot de blindage 5', ou à l'inverse sur la face opposée.

Le composant de l'unité de filtrage 4' recevant le signal d'entrée de l'unité de filtrage 4' (qui peut être, selon les modes de réalisation, un composant inductif ou un composant résistif) est placé, selon les modes de réalisation, en traversée du capot 5' ou à proximité immédiate du capot 5' à l'extérieur de celui-ci. Ainsi, le signal d'entrée (à filtrer) de l'unité de filtrage 4' ne pénètre pas sous le capot de blindage 5', de manière à ne pas perturber le fonctionnement ou les performances des composants du sous-ensemble analogique 3.

A l'inverse, le composant capacitif de l'unité de filtrage 4' est placé sous le capot de blindage 5', de manière à faire le lien avec l'environnement électronique non bruité du sous-ensemble analogique 3 car protégé par le capot de blindage 5'.

Ainsi, le composant d'entrée de l'unité de filtrage 4', placé en série en traversée du capot 5' ou à proximité immédiate du capot 5', fait le lien avec l'environnement électronique du dispositif électronique 1' (et notamment du bloc alimentation/numérique 7') bruité (car non protégé par le capot de blindage 5'), tandis que le composant (capacitif) de sortie de l'unité de filtrage 4', placé sous le capot de blindage 5', fait le lien avec l'environnement électronique non bruité du sous-ensemble analogique 3' car protégé par le capot de blindage 5'.

Si le composant capacitif de sortie de l'unité de filtrage 4' était placé à l'extérieur du capot de blindage 5', l'ensemble de l'unité de filtrage 4' serait placé à l'extérieur du capot de blindage, de sorte que le signal filtré (débruité) en sortie de l'unité de filtrage 4' pourrait à nouveau être bruité avant de pénétrer sous le capot de blindage 5'. L'efficacité de l'unité de filtrage 4' s'en trouverait donc potentiellement fortement amoindrie. En effet, le composant capacitif de l'unité de filtrage 4', s'il était placé à l'extérieur du capot de blindage 5', pourrait lui-même capter du bruit électromagnétique environnant qui viendrait s'ajouter au signal en sortie de l'unité de filtrage 4' et dirigé vers le sous-ensemble analogique 3'. De plus, si le composant capacitif de sortie de l'unité de filtrage 4 était placé à l'extérieur du capot de blindage 5', il serait impossible de placer le composant de filtrage d'entrée de l'unité de filtrage 4' placé en série (sur le chemin de signal) en traversée ou à proximité immédiate du capot de blindage 5'.

Dans un ou plusieurs modes de réalisation, le composant capacitif de l'unité de filtrage 4' (placé sous le capot de blindage 5') permet de créer un chemin de signal de très basse impédance à haute fréquence destiné à favoriser le passage de la composante haute fréquence des signaux à filtrer.

Dans un ou plusieurs modes de réalisation, le composant capacitif de l'unité de filtrage 4' peut être connecté à une masse de manière à diriger vers cette masse les signaux haute fréquence, ce qui permet de filtrer la composante haute fréquence des signaux à filtrer.

Dans un ou plusieurs modes de réalisation, le circuit imprimé de la carte électronique 2' peut être configuré avec un plan de masse comprenant une masse analogique et une masse numérique (parfois aussi appelée masse mécanique) distinctes l'une de l'autre. Sur les figures, une masse numérique est représentée par un symbole râteau, tandis qu'une masse analogique est représentée par une flèche pointant vers le bas. Les masses numériques sont des masses prévues pour recevoir des signaux bruités (par exemple par du bruit de commutation numérique), tandis que les masses analogiques sont, au contraire des masses numériques, prévues pour être isolées de ces signaux bruités. Dans l'exemple de la figure 1b, la partie analogique, comprenant l'interface d'entrée 6' et le sous-ensemble analogique 3', utilise une masse analogique, tandis que la partie alimentation/numérique, comprenant le bloc alimentation/numérique 7', utilise une masse numérique.

Dans un ou plusieurs modes de réalisation, la masse à laquelle est connectée le composant capacitif de l'unité de filtrage 4' (placé sous le capot de blindage 5') sera de préférence une masse analogique, de manière à éviter que du bruit remonte depuis une masse numérique (connecté au composant capacitif) au travers du composant capacitif pour venir perturber le fonctionnement ou les performances du sous-ensemble analogique. Dans un ou plusieurs modes de réalisation, la masse présente à l'intérieur du blindage 5', zone dans laquelle le composant capacitif de l'unité de filtrage 4' sera implanté, sera d'ailleurs de type analogique afin de protéger les composants de cette zone du bruit de masse.

Dans un ou plusieurs modes de réalisation, l'unité de filtrage 4' réalise ainsi une structure filtrante des signaux en entrée par un composant de filtrage (par exemple une inductance et/ou une résistance) placé en traversée du blindage ou à proximité immédiate du blindage (par exemple placé à l'extérieur, mais au plus proche, voire collé au blindage), et les signaux haute fréquence ayant traversé le composant de filtrage (qui constituent des perturbations haute fréquence isolées par le composant de filtrage en entrée de l'unité de filtrage 4') et pénétrant sous le capot de blindage 5' vont être dirigés vers la masse par un composant capacitif de l'unité de filtrage 4' placé sous le capot de blindage 5' et connecté à une masse analogique.

Le type ou les paramètres de filtrage de l'unité de filtrage 4', et notamment la bande passante, pourront bien entendu être choisis en fonction du filtrage souhaité, qui pourra différer selon que l'unité de filtrage est positionnée entre un sous-ensemble numérique comprenant un ou plusieurs composants numériques et le sous-ensemble analogique, ou entre un sous-ensemble d'alimentation comprenant un ou plusieurs composants d'alimentation et le sous-ensemble analogique.

Par exemple, en fonction du mode de réalisation, l'unité de filtrage 4' peut comprendre un composant inductance L et être configurée pour mettre en oeuvre une cellule de filtrage de type LC, ou comprendre un composant résistif R et être configurée pour mettre en oeuvre une cellule de filtrage de type RC.

La Figure 1b illustre un exemple d'interface d'entrée 6' du dispositif 1' configurée pour la réception d'un signal d'entrée radiofréquences, par exemple un signal HF, et être couplée au sous-ensemble analogique 3' pour traitement du signal reçu sur l'interface d'entrée 6 par le sous-ensemble analogique 3'. Par exemple, dans un ou plusieurs modes de réalisation, l'interface d'entrée 6' est alimentée par un bloc d'alimentation faible bruit (non représenté sur la figure) et est agencée pour recevoir un signal de diffusion vidéo modulé d'entrée dans une bande de fréquences d'entrée.

Comme illustré par la Figure 1b, dans un ou plusieurs modes de réalisation, l'interface d'entrée 6' pourra être protégée par le blindage, et par exemple être coaxiale, afin par exemple de pouvoir avantageusement connecter au dispositif 1' un câble coaxial de réception de signaux radiofréquences, comme par exemple un câble de réception de signaux vidéo diffusés par satellite, par reprise de blindage à 360 degrés (sur tout le pourtour du câble) pour protéger l'interface d'entrée 6' par le blindage.

Dans un ou plusieurs modes de réalisation, le bloc alimentation/numérique 7' comprend un sous-ensemble numérique et/ou un sous-ensemble d'alimentation, le sous-ensemble numérique comprenant un ou plusieurs composants numériques, et le sous ensemble d'alimentation comprenant un ou plusieurs composants d'alimentation électrique du sous-ensemble analogique 3'. Ainsi, en fonction du mode de réalisation choisi, la configuration proposée de l'unité de filtrage 4' peut être utilisée pour une unité de filtrage utilisée pour filtrer des signaux issus d'un sous-ensemble numérique ou des signaux issus d'un sous-ensemble d'alimentation.

Ainsi, la configuration proposée d'une unité de filtrage trouve avantageusement à s'appliquer pour le filtrage de signaux fournis au sous-ensemble analogique 3', que ces signaux soient issus d'un sous-ensemble d'alimentation ou qu'ils soient issus d'un sous-ensemble numérique (le type de filtrage mis en oeuvre par l'unité de filtrage 4' pouvant cependant être choisi en fonction du cas de figure).

La figure 1b illustre donc une unité de filtrage 4' comprenant un composant de filtrage (placé, en entrée de l'unité de filtrage, en série sur un chemin de signal connectant électriquement, au sous-ensemble analogique 3', un ou plusieurs composants 7' implantés sur la carte électronique 2' à l'extérieur du blindage 5') et un composant capacitif implanté sous le blindage, dont au moins un composant est, en tout ou partie, implanté à l'extérieur du blindage (composant de filtrage), et au moins un autre composant est implanté à l'intérieur du blindage (composant capacitif). Selon le mode de réalisation, le composant de l'unité de filtrage 4' est positionné en traversée du capot 5' protégeant le sous-ensemble analogique 3' des perturbations électromagnétiques, ou positionné au voisinage immédiat de l'extérieur du blindage 5'. Dans un ou plusieurs modes de réalisation, le composant de filtrage placé en série est implanté en traversée du blindage (par exemple en traversée du capot de blindage du blindage protégeant le sous-ensemble analogique 3'), auquel cas le composant de filtrage est pour partie à l'extérieur du blindage et pour partie à l'intérieur du blindage, de sorte que le signal en sortie de ce composant est alors protégé par le blindage. Dans d'autres modes de réalisation, ce composant de filtrage placé en série est implanté à l'extérieur du blindage et à proximité immédiate du blindage (par exemple en traversée du capot de blindage du blindage protégeant le sous-ensemble analogique 3'), auquel cas le composant de filtrage est implanté à l'extérieur du blindage mais à proximité immédiate de ce blindage de sorte que la longueur du chemin de signal entre la sortie de ce composant et le blindage 5' soit aussi courte que possible (étant donné les contraintes d'implantation des éléments électroniques sur la carte 2'), afin de minimiser autant que possible le chemin de signal en sortie du composant de filtrage placé en série qui n'est pas protégé par le blindage.

Dans un ou plusieurs modes de réalisation, ce composant de filtrage placé en série est implanté en traversée du blindage (par exemple en traversée du capot de blindage du blindage protégeant le sous-ensemble analogique 3'), auquel cas le composant de filtrage est pour partie à l'extérieur du blindage et pour partie à l'intérieur du blindage, de sorte que le signal en sortie de ce composant est alors protégé par le blindage. Dans d'autres modes de réalisation, ce composant de filtrage placé en série est implanté à l'extérieur du blindage et à proximité immédiate du blindage (par exemple en traversée du capot de blindage du blindage protégeant le sous-ensemble analogique 3'), auquel cas le composant de filtrage est implanté à l'extérieur du blindage mais à proximité immédiate de ce blindage de sorte que la longueur du chemin de signal entre la sortie de ce composant et le blindage 5' soit aussi courte que possible (étant donné les contraintes d'implantation des éléments électroniques sur la carte 2'), afin de minimiser autant que possible le chemin de signal en sortie du composant de filtrage placé en série qui n'est pas protégé par le blindage.

La figure 2a montre un exemple d'unité de filtrage selon un ou plusieurs modes de réalisation.

La figure 2a illustre un exemple de mode de réalisation d'une unité de filtrage 4a comprenant une cellule de filtrage de type LC implantée sur un chemin de signal entre un sous-ensemble analogique 3 et un bloc alimentation/numérique 7, tels que ceux illustrés sur les figures la et 1b, en traversée d'un capot 5 de blindage protégeant le sous-ensemble analogique 3.

L'unité de filtrage 4a est ainsi positionnée pour filtrer un signal issu du bloc alimentation/numérique 7 routé vers le sous-ensemble analogique 3, tel que, par exemple, selon le mode de réalisation, un signal de contrôle (par exemple au format d'un bus de type I₂C) issu d'un sous-ensemble numérique du bloc 7, ou un signal d'alimentation issu d'un sous-ensemble d'alimentation.

L'unité de filtrage 4a comprend une cellule de filtrage LC comprenant un composant capacitif 4a2 et un composant inductif 4a1. Dans un ou plusieurs modes de réalisation, le composant capacitif 4a2 est implanté du côté du sous-ensemble analogique 3, dans l'exemple illustré à l'intérieur du capot 5, et le composant inductif 4a1 est implanté du côté du bloc alimentation/numérique 7, dans l'exemple illustré en traversée du capot 5. Le composant inductif 4a1 est placé en entrée de la cellule LC, et opère comme composant de filtrage qui reçoit en entrée les signaux issus du bloc alimentation/numérique 7, pour les filtrer.

Le composant capacitif 4a2 est connecté à une masse analogique, de manière à filtrer, à l'intérieur du capot de blindage 5, le bruit présent dans les signaux issus du composant de filtrage 4a1 dans la bande de fréquence à filtrer, en faisant circuler ce bruit vers la masse analogique. Le composant capacitif 4a2 sera de préférence choisi de manière à présenter une faible impédance dans la bande de fréquence cible du filtrage. Il se comportera comme un fil dans cette bande de fréquence, et le bruit à filtrer sera dirigé vers la masse analogique.

En référence à la Fig. 2a, dans des modes de réalisation où une cellule de filtrage 4a de type LC est utilisée, de manière à améliorer l'efficacité du filtrage entre, d'une part un sous-ensemble analogique 3 comprenant un ou plusieurs composants analogiques et protégé des perturbations électromagnétiques par un capot 5, et d'autre part bloc alimentation/numérique 7 (comprenant un sous-ensemble de composants numériques et/ou un sous-ensemble d'alimentation électrique), le filtrage LC peut être configuré en plaçant le composant inductance 4a1 à cheval sous le capot de blindage 5 entre la partie numérique 7 et la partie analogique 3. La partie basse impédance du filtre LC est ainsi placée dans la partie analogique, sous le blindage protecteur 5.

La figure 2b montre un exemple d'unité de filtrage selon un ou plusieurs modes de réalisation.

La figure 2b illustre un exemple de mode de réalisation d'une unité de filtrage 4b comprenant une cellule de filtrage de type RC implantée sur un chemin de signal entre un sous-ensemble analogique 3 et un bloc alimentation/numérique 7, tels que ceux illustrés sur les figures la et 1b, en traversée d'un capot 5 de blindage protégeant le sous-ensemble analogique 3.

L'unité de filtrage 4b est ainsi positionnée pour filtrer un signal issu du bloc alimentation/numérique 7 routé vers le sous-ensemble analogique 3, tel que, par exemple, selon le mode de réalisation, un signal de contrôle (par exemple au format d'un bus de type I₂C) issu d'un sous-ensemble numérique du bloc 7, ou un signal d'alimentation issu d'un sous-ensemble d'alimentation.

L'unité de filtrage 4b comprend une cellule de filtrage RC comprenant un composant capacitif 4b2 et un composant résistif 4b1. Dans un ou plusieurs modes de réalisation, le composant capacitif 4b2 est implanté du côté du sous-ensemble analogique 3, dans l'exemple illustré à l'intérieur du capot 5, et le composant résistif 4b1 est implanté du côté du bloc alimentation/numérique 7, dans l'exemple illustré en traversée du capot 5. Le composant résistif 4b1 est placé en entrée de la cellule RC, et opère comme composant de filtrage qui reçoit en entrée les signaux issus du bloc alimentation/numérique 7, pour les filtrer.

Le composant capacitif 4b2 est connecté à une masse analogique, de manière à filtrer, à l'intérieur du capot de blindage 5, le bruit présent dans les signaux issus du composant de filtrage 4b1 dans la bande de fréquence à filtrer, en faisant circuler ce bruit vers la masse analogique. Le composant capacitif 4b2 sera de préférence choisi de manière à présenter une faible impédance dans la bande de fréquence cible du filtrage. Il se comportera comme un fil dans cette bande de fréquence, et le bruit à filtrer sera dirigé vers la masse analogique.

En référence à la Fig. 2b, dans des modes de réalisation où une cellule de filtrage 4b de type RC est utilisée, de manière à améliorer l'efficacité du filtrage entre, d'une part un sous-ensemble analogique 3 comprenant un ou plusieurs composants analogiques et protégé des perturbations électromagnétiques par un capot 5, et d'autre part bloc alimentation/numérique 7 (comprenant un sous-ensemble de composants numériques et/ou un sous-ensemble d'alimentation électrique), le filtrage RC peut être configuré en plaçant le composant résistif 4b1 à cheval sous le capot de blindage 5 entre la partie numérique 7 et la partie analogique 3. La partie basse impédance du filtre RC est ainsi placée dans la partie analogique 3, sous le blindage protecteur 5.

La figure 2c montre un exemple d'unité de filtrage selon un ou plusieurs modes de réalisation.

La figure 2c illustre un exemple de mode de réalisation d'une unité de filtrage 4c comprenant une cellule de filtrage de type LC implantée sur un chemin de signal entre un sous-ensemble analogique 3 et un bloc alimentation/numérique 7, tels que ceux illustrés sur les figures la et 1b, sans traversée d'un capot 5 de blindage protégeant le sous-ensemble analogique 3.

L'unité de filtrage 4c est ainsi positionnée pour filtrer un signal issu du bloc alimentation/numérique 7 routé vers le sous-ensemble analogique 3, tel que, par exemple, selon le mode de réalisation, un signal de contrôle (par exemple au format d'un bus de type I₂C) issu d'un sous-ensemble numérique du bloc 7, ou un signal d'alimentation issu d'un sous-ensemble d'alimentation.

L'unité de filtrage 4c comprend une cellule de filtrage LC comprenant un composant capacitif 4c2 et un composant inductif 4c1. Dans un ou plusieurs modes de réalisation, le composant capacitif 4c2 est implanté du côté du sous-ensemble analogique 3, dans l'exemple illustré à l'intérieur du capot 5, et le composant inductif 4c1 est implanté du côté du bloc alimentation/numérique 7, dans l'exemple illustré à l'extérieur du capot 5 et à proximité immédiate du capot 5. Le composant inductif 4c1 est placé en entrée de la cellule LC, et opère comme composant de filtrage qui reçoit en entrée les signaux issus du bloc alimentation/numérique 7, pour les filtrer.

Le composant inductif 4c1 est placé au plus proche du capot 5 de manière à minimiser autant que possible le chemin de signal entre la sortie du composant inductif 4c1 et le capot 5, afin d'éviter toute capture de bruit environnant qui viendrait diminuer l'efficacité du filtrage réalisé par l'unité de filtrage 4c. Dans un ou plusieurs modes de réalisation, le composant inductif 4c1 pourra être placé au plus près du capot 5 à l'extérieur de celui-ci, de manière à ce que la longueur de la portion de chemin de signal entre la sortie du composant inductif 4c1 et le capot 5 soit minime, voire quasiment nulle, afin que les perturbations provoqué par le bruit capté par cette portion soient négligeables.

Le composant capacitif 4c2 est connecté à une masse analogique, de manière à filtrer, à l'intérieur du capot de blindage 5, le bruit présent dans les signaux issus du composant de filtrage 4c1 dans la bande de fréquence à filtrer, en faisant circuler ce bruit vers la masse analogique. Le composant capacitif 4c2 sera de préférence choisi de manière à présenter une faible impédance dans la bande de fréquence cible du filtrage. Il se comportera comme un fil dans cette bande de fréquence, et le bruit à filtrer sera dirigé vers la masse analogique

En référence à la Fig. 2c, dans des modes de réalisation où une cellule de filtrage 4c de type LC est utilisée, de manière à améliorer l'efficacité du filtrage entre, d'une part un sous-ensemble analogique 3 comprenant un ou plusieurs composants analogiques et protégé des perturbations électromagnétiques par un capot 5, et d'autre part un bloc alimentation/numérique 7 (comprenant un sous-ensemble de composants numériques et/ou un sous-ensemble d'alimentation électrique), le filtrage LC peut être configuré en plaçant le composant inductance 4c1 au plus près du capot de blindage 5 entre la partie numérique 7 et la partie analogique 3, tandis que le composant capacitif 4c2 reste placé sous le capot de blindage 5. La partie basse impédance du filtre LC est ainsi placée dans la partie analogique 3, sous le blindage protecteur 5.

La figure 2d montre un exemple d'unité de filtrage selon un ou plusieurs modes de réalisation.

La figure 2d illustre un exemple de mode de réalisation d'une unité de filtrage 4d comprenant une cellule de filtrage de type RC implantée sur un chemin de signal entre un sous-ensemble analogique 3 et un bloc alimentation/numérique 7, tels que ceux illustrés sur les figures la et 1b, en traversée d'un capot 5 de blindage protégeant le sous-ensemble analogique 3.

L'unité de filtrage 4d est ainsi positionnée pour filtrer un signal issu du bloc alimentation/numérique 7 routé vers le sous-ensemble analogique 3, tel que, par exemple, selon le mode de réalisation, un signal de contrôle (par exemple au format d'un bus de type I₂C) issu d'un sous-ensemble numérique du bloc 7, ou un signal d'alimentation issu d'un sous-ensemble d'alimentation.

L'unité de filtrage 4d comprend une cellule de filtrage RC comprenant un composant capacitif 4d2 et un composant résistif 4d1. Dans un ou plusieurs modes de réalisation, le composant capacitif 4d2 est implanté du côté du sous-ensemble analogique 3, dans l'exemple illustré à l'intérieur du capot 5, et le composant résistif 4d1 est implanté du côté du bloc alimentation/numérique 7, dans l'exemple illustré à l'extérieur du capot 5 et à proximité immédiate du capot 5. Le composant résistif 4d1 est placé en entrée de la cellule RC, et opère comme composant de filtrage qui reçoit en entrée les signaux issus du bloc alimentation/numérique 7, pour les filtrer.

Le composant résistif 4d1 est placé au plus proche du capot 5 de manière à minimiser autant que possible le chemin de signal entre la sortie du composant résistif 4d1 et le capot 5, afin d'éviter toute capture de bruit environnant qui viendrait diminuer l'efficacité du filtrage réalisé par l'unité de filtrage 4d. Dans un ou plusieurs modes de réalisation, le composant résistif 4d1 pourra être placé au plus près du capot 5 à l'extérieur de celui-ci, de manière à ce que la longueur de la portion de chemin de signal entre la sortie du composant résistif 4d1 et le capot 5 soit minime, voire quasiment nulle, afin que les perturbations provoqué par le bruit capté par cette portion soient négligeables. Le composant capacitif 4d2 est connecté à une masse analogique, de manière à filtrer, à l'intérieur du capot de blindage 5, le bruit présent dans les signaux issus du composant de filtrage 4d1 dans la bande de fréquence à filtrer, en faisant circuler ce bruit vers la masse analogique. Le composant capacitif 4d2 sera de préférence choisi de manière à présenter une faible impédance dans la bande de fréquence cible du filtrage. Il se comportera comme un fil dans cette bande de fréquence, et le bruit à filtrer sera dirigé vers la masse analogique.

En référence à la Fig. 2d, dans des modes de réalisation où une cellule de filtrage 4d de type RC est utilisée, de manière à améliorer l'efficacité du filtrage entre, d'une part un sous-ensemble analogique 3 comprenant un ou plusieurs composants analogiques et protégé des perturbations électromagnétiques par un capot 5, et d'autre part bloc alimentation/numérique 7 (comprenant un sous-ensemble de composants numériques et/ou un sous-ensemble d'alimentation électrique), le filtrage RC peut être configuré en plaçant le composant résistif 4d1 au plus près du capot de blindage 5 entre la partie numérique 7 et la partie analogique 3, tandis que le composant capacitif 4d2 reste placé sous le capot de blindage 5. La partie basse impédance du filtre RC est ainsi placée dans la partie analogique 3, sous le blindage protecteur 5.

La figure 3 illustre un exemple de dispositif électronique selon un ou plusieurs modes de réalisation.

Le dispositif 10 de la figure 3 comprend une carte électronique 20 sur laquelle sont implantés un sous-ensemble analogique 3, un sous-ensemble alimentation 7_1, un sous-ensemble numérique 7 2, deux unités de filtrage 4_1 et 4 2, et une interface d'entrée 6. Le sous-ensemble analogique 3 est protégé des perturbations électromagnétiques extérieures par un blindage, prenant par exemple la forme d'un capot 5.

Dans un ou plusieurs modes de réalisation, le sous-ensemble analogique 3 comprend un ou plusieurs composants analogiques radiofréquences, par exemple hautes fréquences (HF), susceptibles d'être alimentés par un signal hautes fréquences.

En particulier, le dispositif proposé trouvera avantageusement à s'appliquer pour un sous-ensemble analogique 3 du type comprenant un ou plusieurs composants analogiques de réception radiofréquences à faible niveau. Du fait de la sensibilité de ce type de sous-ensemble analogique à des niveaux de bruit qui sont grands relativement au niveau de signal traité par les composants du sous-ensemble analogique, le fonctionnement du sous-ensemble analogique aux performances attendues ne pourra être obtenu qu'en protégeant ce sous-ensemble analogique du bruit extérieur (incluant les perturbations électromagnétiques extérieures) par un blindage, prenant par exemple la forme d'un capot 5.

Dans un ou plusieurs modes de réalisation, le sous-ensemble numérique 72 comprend un ou plusieurs composants numériques et est configuré pour générer un ou plusieurs signaux de contrôle (CTRL) pour contrôler le sous-ensemble analogique 3. Le sous ensemble d'alimentation 7_1 comprend un ou plusieurs composants d'alimentation électrique du sous-ensemble analogique 3 et est configuré pour générer un signal d'alimentation du sous-ensemble analogique 3.

L'unité de filtrage 4_1 est positionnée de manière à augmenter l'efficacité de filtrage de signaux d'alimentation issus du sous-ensemble d'alimentation 7_1 routés vers le sous-ensemble analogique 3 à l'intérieur du capot 5.

L'unité de filtrage 4_2 est positionnée de manière à augmenter l'efficacité de filtrage de signaux différentiels de contrôle CTRL issus du bloc numérique 7 2 routés vers le sous-ensemble analogique 3 à l'intérieur du capot 5.

Le type ou les paramètres de filtrage de chacune des unités de filtrage 4_1 et 4 2, et notamment la bande passante, pourront bien entendu être choisis en fonction du filtrage souhaité, qui pourra différer selon que l'unité de filtrage est positionnée entre un sous-ensemble numérique 7 2 comprenant un ou plusieurs composants numériques et le sous-ensemble analogique 3, ou entre un sous-ensemble d'alimentation 7_1 comprenant un ou plusieurs composants d'alimentation et le sous-ensemble analogique 3.

La figure 3 montre des unités de filtrage 4_1 et 4_2 qui chacune comprennent au moins une cellule de filtrage de type LC. Afin de filtrer chacun des chemins de signal des signaux différentiels issus du sous-ensemble numérique 7 2, l'unité de filtrage 4_2 comprend deux cellules de filtrage de type LC, chacune positionnée sur un chemin de signal d'un signal de contrôle issu du sous-ensemble numérique 7 2 selon un mode de réalisation de configuration proposé.

Néanmoins, l'homme du métier pourra se rendre compte que tous autres types ou paramètres de filtrage convenant pour un filtrage de signaux d'alimentation et/ou, selon les cas de figure, un filtrage de signaux numérique (par exemple de signaux de contrôle comme illustré par la figure 3), pourront être utilisés à la place ou en complément cellules de filtrage LC 4_1 et 4 2, qui sont décrites seulement à titre d'exemple. Par exemple, en fonction du mode de réalisation, chacune des unités de filtrage 4_1 et 4_2 peut comprendre un composant inductance L et être configurée pour mettre en oeuvre une cellule de filtrage de type LC, ou comprendre un composant résistif R et être configurée pour mettre en oeuvre une cellule de filtrage de type RC.

La figure 3 illustre des modes de réalisations dans lesquels chacune des unités de filtrage 4_1 est positionnée en traversée du capot 5 protégeant le sous-ensemble analogique 3 des perturbations électromagnétiques, en ce que chacun des composants inductifs respectifs des cellules LC des unités de filtrage 4_1 et 4_2 est positionné sur la carte électronique 20 à cheval (en traversée) sous le capot de protection 5. Les composants capacitifs respectifs des cellules LC des unités de filtrage 4_1 et 4_2 sont positionnés sur la carte électronique 20 sous le capot de protection 5.

L'interface d'entrée 6 du dispositif peut être configurée pour la réception d'un signal d'entrée radiofréquences, par exemple un signal HF, et être couplée au sous-ensemble analogique 3 pour traitement du signal reçu sur l'interface d'entrée 6 par le sous-ensemble analogique 3. Par exemple, dans un ou plusieurs modes de réalisation, l'interface d'entrée est alimentée par un bloc d'alimentation faible bruit (non représenté sur la figure) et est agencée pour recevoir un signal de diffusion vidéo modulé d'entrée dans une bande de fréquences d'entrée.

Dans un ou plusieurs modes de réalisation, l'interface d'entrée 6 pourra être protégée par le blindage, et par exemple être coaxiale, afin par exemple de pouvoir avantageusement connecter au dispositif 10 un câble coaxial de réception de signaux radiofréquences, comme par exemple un câble de réception de signaux vidéo diffusés par satellite, par reprise de blindage à 360 degrés (sur tout le pourtour du câble) pour protéger l'interface d'entrée 6 par le blindage.

Ainsi, la configuration proposée d'une unité de filtrage trouve avantageusement à s'appliquer pour le filtrage de signaux fournis au sous-ensemble analogique 3, que ces signaux soient issus d'un sous-ensemble d'alimentation 7_1 ou qu'ils soient issus d'un sous-ensemble numérique 7_2 (le type de filtrage mis en oeuvre par l'unité de filtrage 4 pouvant cependant être choisi en fonction du cas de figure).

La configuration du dispositif 10 illustré sur la Fig. 3 peut avantageusement être mise en oeuvre sur une carte d'acquisition de signaux vidéo diffusés.

L'homme du métier pourra néanmoins se rendre compte que le dispositif proposé n'est pas limité à un type particulier d'application, et que les solutions techniques et avantages décrits ci-dessus en lien avec les exemples non limitatifs de dispositif des figures la, 1b et 3 sont utilisables pour tous types de cartes électroniques sur lesquelles sont implantés un sous-ensemble analogique, un sous-ensemble numérique et/ou un sous-ensemble d'alimentation, et une unité de filtrage de signal entre le sous-ensemble analogique et l'un parmi le sous-ensemble numérique et le sous-ensemble d'alimentation.

### Application industrielle

En fonction du mode de réalisation choisi, certains actes, actions, évènements ou fonctions de chacune des méthodes décrites dans le présent document peuvent être effectués ou se produire selon un ordre différent de celui dans lequel ils ont été décrits, ou peuvent être ajoutés, fusionnés ou bien ne pas être effectués ou ne pas se produire, selon le cas. En outre, dans certains modes de réalisation, certains actes, actions ou évènements sont effectués ou se produisent concurremment et non pas successivement.

Bien que décrits à travers un certain nombre d'exemples de réalisation détaillés, le procédé proposé et le dispositif pour la mise en oeuvre d'un mode de réalisation du procédé comprennent différentes variantes, modifications et perfectionnements qui apparaîtront de façon évidente à l'homme de l'art, étant entendu que ces différentes variantes, modifications et perfectionnements font partie de la portée de l'invention, telle que définie par les revendications qui suivent. De plus, différents aspects et caractéristiques décrits ci-dessus peuvent être mis en oeuvre ensemble, ou séparément, ou bien substitués les uns aux autres, et l'ensemble des différentes combinaisons et sous-combinaisons des aspects et caractéristiques font partie de la portée de l'invention. En outre, il se peut que certains systèmes et équipements décrits ci-dessus n'incorporent pas la totalité des modules et fonctions décrits pour les modes de réalisation préférés.

## Revendications

1. Dispositif électronique comprenant une carte électronique sur laquelle sont implantés, un sous-ensemble analogique et une unité de filtrage, le sous-ensemble analogique comprenant un ou plusieurs composants analogiques,
dans lequel le sous-ensemble analogique est protégé par un blindage implanté sur une face de la carte électronique,
dans lequel l'unité de filtrage est implantée sur la face de la carte électronique sur un chemin de signal connecté électriquement au sous-ensemble analogique,
dans lequel l'unité de filtrage comprend un composant capacitif implanté sous le blindage et connecté à une masse analogique,
et dans lequel l'unité de filtrage comprend en outre un composant de filtrage placé en entrée de l'unité de filtrage en série sur le chemin de signal en traversée du blindage ou au voisinage immédiat de l'extérieur du blindage.

2. Dispositif selon la revendication 1, comprenant en outre un bloc alimentation/numérique implanté sur la carte électronique, le bloc alimentation/numérique comprenant un sous-ensemble numérique et/ou un sous-ensemble d'alimentation, le sous-ensemble numérique comprenant un ou plusieurs composants numériques, et le sous ensemble d'alimentation comprenant un ou plusieurs composants d'alimentation électrique du sous-ensemble analogique, dans lequel l'unité de filtrage est implantée entre le sous-ensemble analogique et le bloc alimentation/numérique.

3. Dispositif selon la revendication 2, dans lequel le chemin de signal est entre le sous-ensemble analogique et le sous-ensemble numérique.

4. Dispositif selon la revendication 3, dans lequel l'unité de filtrage est configurée pour filtrer un signal de contrôle issu du sous-ensemble numérique pour contrôler le sous-ensemble analogique.

5. Dispositif selon la revendication 2, dans lequel le chemin de signal est entre le sous-ensemble analogique et le sous-ensemble d'alimentation.

6. Dispositif selon la revendication 5, dans lequel l'unité de filtrage est configurée pour filtrer un signal d'alimentation issu du sous-ensemble alimentation pour alimenter électriquement le sous-ensemble analogique.

7. Dispositif selon l'une quelconque des revendications précédentes, dans lequel l'unité de filtrage comprend une cellule de filtrage de type LC ou RC.

8. Dispositif selon l'une quelconque des revendications précédentes, dans lequel le blindage comprend un capot de blindage, et dans lequel le composant de filtrage placé en série sur le chemin de signal est placé en traversée du capot de blindage ou au voisinage immédiat du capot de blindage.

9. Dispositif selon l'une quelconque des revendications précédentes, dans lequel le blindage comprend un capot de blindage, et dans lequel le composant de filtrage placé en série est un composant inductance placé en série à cheval sous le capot de blindage entre le bloc alimentation/numérique et le sous-ensemble analogique.

10. Dispositif selon l'une quelconque des revendications 1 à 8, dans lequel le blindage comprend un capot de blindage, et dans lequel le composant de filtrage placé en série est un composant résistif placé en série à cheval sous le capot de blindage entre le bloc alimentation/numérique et le sous-ensemble analogique.

11. Dispositif selon l'une quelconque des revendications précédentes, dans lequel le sous-ensemble analogique comprend un ou plusieurs composants analogiques de réception de signaux radiofréquences.
